# EUROPEAN PATENT SPECIFICATION

(11) **EP 1 804 541 B1**
(45) Date of publication and mention of the grant of the patent: **21.11.2012**
(21) Application number: 05388118.1
(22) Date of filing: 27.12.2005
(51) Int. Cl.: H04W 4/06

(54) **Method, system, device and computer-readable medium for communicating incremental broadcast information**
Verfahren, System, Vorrichtung und computerlesbares Medium zur Übertragung inkrementaler Rundsendeinformationen
Procédé, système, dispositif et support lisible sur ordinateur de communication d'informations incrémentièlles de diffusion

(43) Date of publication of application: 04.07.2007
(73) Proprietor: Telefonaktiebolaget L M Ericsson (Publ), 164 83 Stockholm (SE)
(72) Inventor: Haartsen, Jacobus Cornelis, 7772 BG Hardenberg (NL)
(74) Representative: Andersson, Karl Ola

(56) References cited:
- US-A- 5 404 355
- US-A- 5 577 087
- US-A- 6 125 148
- US-A1- 2005 113 087
- US-B1- 6 643 333

## Description

### FIELD OF THE INVENTION

The invention generally relates to communications systems and, more particularly, to digital communications systems transmitting broadcast control information. More specifically, the invention relates to a system for, a transmitting unit for, a computer readable medium, a use of a terminal and a method of communicating broadcast information, and a method of communicating broadcast information, the method comprising transmitting broadcast information comprising a first and a second part to at least one communications terminal.

### BACKGROUND OF THE INVENTION

Broadcast channels are very important in cellular communications systems. Broadcast Control Channels (BCCHs) are used by a network to identify cells and are instrumental in the call setup procedures. Typically, the standby behavior of a terminal is largely determined by the structure of the Broadcast Control Channel (BCCH). Normally, the BCCH (in other systems also typically referred to as a beacon channel) applies a low duty cycle transmission so that the terminal can 'sleep' for most of the time thereby reducing power consumption. Periodically, the terminal needs to 'wake up' and listen to the BCCH in order to check for paging messages on the paging channel (PCH) and to determine whether the current cell is still the cell to camp on (cell search).

In addition to Broadcast Control Channels (BCCHs), Broadcast Traffic Channels (BTCHs) can be supported by the network. The BTCHs are used to transfer data and/or voice over the network and can be part of a cellular network, e.g. like Multimedia Broadcast and Multicast Services (MBMS) are in a Universal Mobile Telephone System (UMTS) network or they can e.g. be provided by a stand-alone infra-structure e.g. like such used for Digital Audio Broadcast (DAB), Digital Video Broadcast Terrestrial (DVB-T) and Digital Video Broadcast Handheld (DVB-H), etc.

Broadcast channels tend to be very robust since they act as 'life lines' for the terminals to the network. They are required to support terminals both close to the base station and far away from the base station. The power consumption in the terminals while receiving the broadcast information depends on a number of factors like the size of the broadcast message, the information rate on the air interface, the duty cycle of the broadcast message, etc.

The size of the broadcast message depends on the specific system. For the BCCH it may include, among other things, the network identity, the cell (base station) identity, a list of neighboring cell identities, interface parameters (e.g. the permitted transmission power levels), synchronization information, paging information, etc. The information rate is typically determined by the air interface parameters like the bandwidth, the modulation scheme, the coding scheme, and the spreading factor. The duty cycle determines the overhead in the downlink transmissions from the network's point of view and the latency (in channel setup and network access) from the terminal's point of view.

In order to minimize the power consumption in a terminal while locked to a given broadcast channel it is beneficial to have 1) short broadcast messages, 2) high data rates, and 3) a low duty cycle (i.e. a small amount of time or length of the active part of a cycle compared to the overall time or total length of the cycle).

Current structures of the BCCH and BTCH do not take into account different propagation conditions in the terminals (some terminals are close to the base station while others are at the cell edge and some are in a fading dip and others have line-of-sight). Additionally, improved air interface modes with higher information rates like EDGE (Enhanced Data rates for GSM Evolution) in GSM (Global System for Mobile communications) or HSDPA (High Speed Downlink Packet Access) in UMTS or varying spectrum allocation by operator and country are also not taken into consideration.

Currently, BCCH and BTCH are designed for the worst case, i.e. the performance of all terminals while receiving broadcast information is determined by the terminals located at the cell edge using the lowest information rate and/or at the smallest bandwidth. Terminals closer to the base station, terminals that can support higher data rates, and terminals that can support wider bandwidths cannot exploit these features to reduce the standby power consumption while listening to the broadcast channels.

Patent specification US 6,643,333 discloses a communications system where a block of N data symbols are divided into a plurality of partial blocks each partial block having Ns data symbols. The Ns data symbols are allocated to sub-carries and are modulated in parallel onto these sub-carriers, where the modulation for each of the sub-carriers is carried out with at least one individual code symbol. The sub-carriers are heterodyned to form a broadband carrier so that the Ns data symbols are transmitted simultaneously whereby the transmission is carried out in N/Ns successive partial blocks. If one data symbol is transmitted on a plurality of sub-carriers then frequency diversity for the data symbol is ensured making the transmission more interference resistant.

It is mentioned that the number of data symbols in a partial block can be varied depending on the transmission conditions of the radio interface thereby varying the bit or information rate on the basis of transmission conditions. Further, the number of sub-carriers allocated to one data symbol can be varied depending on the transmission conditions of the radio interface thereby making it possible to match the interference immunity to the transmission conditions and manage the frequency resources economically. Power conservation of terminals is not addressed.

Patent specification US 5,577,087 discloses variable modulation communication where one modulation scheme, 16-Quadrature Amplitude Modulation (16-QAM), is used during communication for terminals close to the base station while another modulation scheme, Quadrature Phase Shift Keying (QPSK), is used for terminals more remote from the base station, i.e. under more noisy conditions. The determination of which demodulation scheme to use is based on reception of a control signal from the base station in a given terminal during idle time and more specifically on the basis of the reception power in the given terminal. A request for a given modulation scheme is then sent to the base station when communication is requested and communication with the terminal is done according to the requested modulation scheme at the terminal's allocated time slot. Other terminals may use the same or the other modulation scheme (depending on their power level) in their allocated time slots which all are different. No special arrangement of broadcast information is disclosed and the terminals simply communicate with the base station according to a requested modulation scheme. Power conservation of terminals is not addressed.

Patent specification US 6,125,148 discloses demodulation in a communications system that supports multiple modulation schemes but using an identical demodulator where data or voice is communicated over a traffic channel using a first linear modulation scheme (e.g. 16-QAM) and where a control channel associated with the traffic channel uses a second linear modulation scheme (e.g. QPSK) for communicating associated control information. Power conservation of terminals is not addressed.

The article "Turbo-coded Hybrid ARQ using various segment selective repeat" by Tao Shi et al., IEEE 6th CAS Symp. On Emerging Technologies: Mobile and Wireless Comm., Shanghai, China, May 31 - June 2, 2004, discloses segment selective repeat (SSR) as a re-transmission strategy for turbo-coded hybrid automatic repeat requests. Turbo codes are a means of forward error correction (FEC). When decoding errors are detected then only some segments being estimated as the worst corruption are to be retransmitted and SSR is used to avoid unnecessary retransmission of the whole packet. Power conservation of terminals is not addressed.

Patent application US 2005/0113087 A1 discloses transmission of a paging message consisting of four bursts from a base station to a terminal. The terminal may, in order to increase standby time, attempt to recover the paging message from the base station when the second burst is received and thereby before the reception of the entire message. The state (correct reception or error reception) of the recovered message is checked against the parity bits. If correct reception has occurred, the terminal may go to sleep.

If the message is not recovered without error after the reception of the second burst, the third burst is recovered. Again, if the message recovered is error free, the terminal goes to sleep and otherwise the fourth burst is received etc.

### OBJECT AND SUMMARY OF THE INVENTION

It is an object of the present invention to provide a broadcast channel that is flexible and not only dimensioned for the worst case conditions.

It is a further object to provide a method and a system that can improve the power consumption of terminals not under worst case conditions while listening to broadcast channels and still support terminals under less favorable conditions.

Another object is to enable more capable terminals and/or under favorable communications conditions to receive information faster while still maintaining support for terminals being less capable and/or under less favorable communications conditions.

These objects, among others, are achieved by the method according to claim 1.

Incremental broadcast information is additional information that is transmitted to allow narrowband terminals or terminals under unfavorable or less favorably propagation conditions to receive the entire broadcast message correctly.

The beneficial use of incremental broadcast information may e.g. arise from the fact that the data/information rate is not high enough in certain terminals to accommodate all the broadcast information as fast as other terminals are capable of. This can e.g. be caused by a narrow available bandwidth, i.e. only a limited available transmission bandwidth and e.g. therefore only a limited number of Orthogonal Frequency Division Multiplexing (OFDM) sub-carries. It can also be caused by a low spectral efficiency (typically expressed in number of bits/Hz), i.e. the number of bits per symbol or caused by the complexity or information rate/level of the used constellation diagram for the used encoding schemes of certain terminals. Further, it can be caused by the fact that forward-error-correction coding (also typically referred to as incremental redundancy) is required for error-free demodulation of the broadcast message.

In this way, a terminal having wide-band capability is able to receive the broadcast information more quickly, whereas the information that is sent as incremental information at a later point in time also serves the less capable or less favorable terminals.

This saves power for the more capable and/or favorable placed terminals since the transceiver will be active for a shorter amount of time to receive the same amount of broadcast information.

A communications terminal may e.g. be a mobile phone, a Personal Digital Assistant (PDA), a PC, a Consumer Electronics (CE) device, a media-device, a TV-terminal or TV receiver communicating with a satellite or like, etc. In general, the terminal(s) can be any (stationary or portable) electronic device with wireless communication capabilities.

In one embodiment, the incremental broadcast information comprises one or more selected from the group of:
- broadcast information that has been transmitted at said first time instance,
- channel coding information,
- one or more parity bits, and
- one or more bits of information of an error correction scheme.

In one embodiment, the broadcast information comprises a number of parts wherein one part is transmitted at a first frequency range at said first time instance and wherein at least one of the other parts is transmitted at another frequency range at said first time instance, and where the at least one of the other parts is re-transmitted as incremental information at said time instance being different from the first time instance.

In this way, a terminal having wide band capability is able to receive the broadcast information more quickly where the information that is sent at the additional frequency ranges is sent as incremental information so that the less capable or less favorably terminals will still be able to receive the information (although at a later point in time).

In one embodiment, the time instance being different from the first time instance is a time instance that is later in time than the first time instance. When the incremental information is sent later, a capable terminal may receive information it missed (e.g. due to some temporary fade or glitch) when that information is sent (again) as incremental information.

In one embodiment, a systematic encoder outputs information bits as said broadcast information and a number of parity bits as said incremental broadcast information where the information bits are transmitted first followed by one or more of the parity bits.

In this way, a terminal with a good signal-to-noise ratio is able to receive the broadcast information more quickly.

In one embodiment, the parity bits are re-ordered by an interleaver before being transmitted. This enables randomization of the parity bits which increases the robustness in the decoding scheme.

In one embodiment, a first and at least a second modulation scheme are supported during transmission and where the method comprises transmitting the broadcast information according to the first modulation scheme and transmitting the incremental broadcast information according to the second modulation scheme, where the first modulation scheme has a higher information rate than the second modulation scheme and where information transmitted in the second modulation scheme is transmitted as a part of the information in the first modulation scheme in at least one time instance.

In one embodiment, the first modulation scheme is 16-QAM, the second modulation scheme is QPSK and the broadcast information has a size of 8 bits, where the broadcast information is arranged in a first block (b_0, b_1), a second block (b_2, b_3), a third block (b_4, b_5) and a fourth block (b_6, b_7), each of 2 bits, where
- the first and second blocks (b_0, b_1, b_2, b_3) are transmitted as the first symbol so that the first block (b_0, b_1) can be received according to both QPSK and to 16-QAM and so that the second block (b_2, b_3) can be received according to 16-QAM,
- the third and fourth blocks (b_4, b_5, b_6, b_7) are transmitted as the second symbol so that the third block (b_4, b_5) can be received according to both QPSK and to 16-QAM and so that the fourth block (b_6, b_7) can be received according to 16-QAM,
- the second block (b_2, b_3) is transmitted as the third symbol and is transmitted as incremental information so that it can be received according to QPSK, and
- the fourth block (b_6, b_7) is transmitted as the fourth symbol and is transmitted as incremental broadcast information so that it can be received according to QPSK.

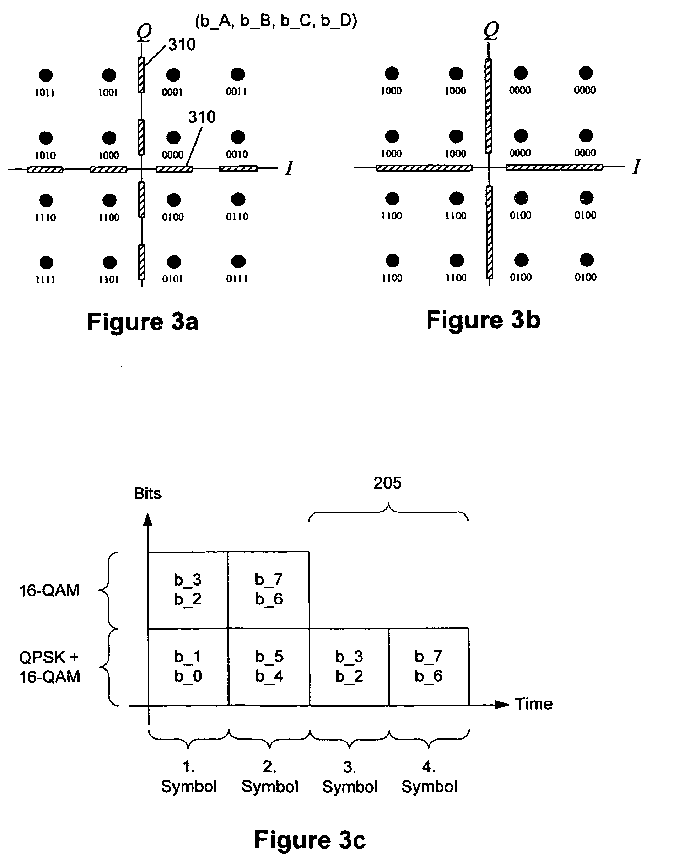

In one embodiment, a first and at least a second modulation scheme are supported during transmission and where the method comprises transmitting the broadcast information according to the first modulation scheme and transmitting the incremental broadcast information according to the second modulation scheme, where said first modulation scheme comprises N constellation points and said second modulation scheme comprises M constellation points, where N and M are integers and M<N and where said M constellation points are a sub-constellation of the N constellation points and where information sent in the second modulation scheme is sent as a part of the information in the first modulation scheme in at least one time instance. Preferably, the information sent in the second modulation scheme is sent only as a part of the first modulation scheme only as long as the first modulation scheme is used (e.g. in the first and 2. symbol slot in Figure 3c).

In another embodiment, constellation points of the first modulation scheme that is used for constellation points of the second modulation scheme are selected to be points that have the biggest mutual spacing. This is advantageously as there is no information left for the 16-QAM terminal(s) (so it does not matter which symbol is used as long as it is in the same Q-I quadrant), whereas these constellation points have the best distance properties thereby giving the best error tolerance.

In one embodiment, a first and at least a second modulation scheme are supported during transmission and where the method comprises transmitting the broadcast information according to the first modulation scheme and transmitting the incremental broadcast information according to the at least second modulation scheme, where the first modulation scheme is selected from the group of: 16-QAM and 64-QAM and where the at least second modulation scheme is one or more selected from the group of QPSK and 16-QAM.

In one embodiment, constellation points in a Q-I space are non-equidistant, where constellation points within a given cluster are substantially equidistant and where clusters of constellation points are placed further apart compared to a placement of clusters of constellation points, where all the constellation points are equidistant.

In this way, the clusters (a cluster being a group of symbols in one scheme representing the same symbol in the other scheme) are spaced further apart thereby improving the error rate even more than already achieved due to the merging or mapping symbols into clusters.

The present invention also relates to a system for communicating broadcast information according to claim 14.

Advantageous embodiments of the system are defined in the sub-claims and described in detail in the following.

Further, the invention also relates to a computer readable medium having stored thereon instructions for causing one or more processing units to execute the method according to claims 1 to 13.

Further, the invention also relates to a transmitter unit according to claim 27.

### BRIEF DESCRIPTION OF THE DRAWINGS

These and other aspects of the invention will be apparent from and elucidated with reference to the illustrative embodiments shown in the drawings, in which:
Figure 1 schematically illustrates a network comprising a base station and a number of terminals;
Figure 2 schematically illustrates the use of incremental broadcast information according to one embodiment of the present invention;
Figures 3a - 3e schematically illustrate different modulation schemes and different embodiments in order to provide different information rates to terminals within a cell;
Figure 4 schematically illustrates an encoder according to one embodiment, of the present invention;
Figure 5 schematically illustrates broadcast information parts distributed in time and frequency according to another embodiment of the present invention; and
Figures 6a, 6b, 6c and 6d illustrate an alternative embodiment than the one primarily described in connection with Figures 3a - 3e.

### DESCRIPTION OF PREFERRED EMBODIMENTS

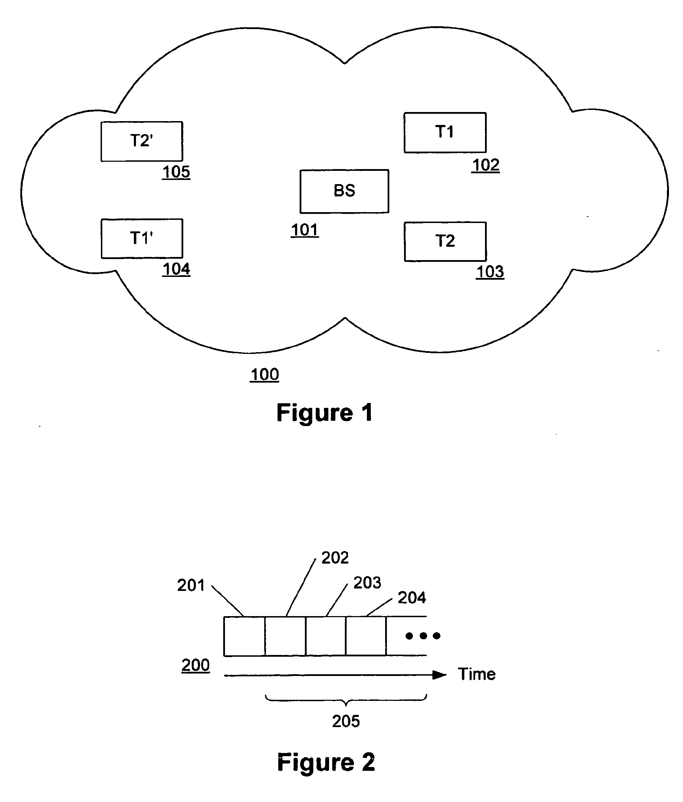

Figure 1 schematically illustrates a network comprising a base station and a number of terminals. Shown, as an example, is a cell (100) of a communications network like GSM, EDGE in GSM, UMTS, or the like that comprises a base station (BS) (101) that supports a number of terminals (102, 103, 104, 105) within the cell (100).

Shown, as an example, are two terminals (T1, T1') (102, 104) that are low-cost and/or low-complexity terminals e.g. having low or medium information rate and/or small or medium bandwidth, etc. where one of the terminals (T1) is located in near-optimal or optimal conditions (e.g. near to the base station (101), having favorable propagation conditions, having line-of-sight to the base station (101), and/or the like). The other terminal (T1') of the two terminals is located in near-worst case, worst case, or less favorable conditions (e.g. relatively far away from the base station (101), at the cell edge, in a fading dip, and/or the like).

Further shown, as an example, are two other terminals (T2, T2') (103, 105) that are more advanced e.g. capable of high(er) information rate, high(er) bandwidth, and/or the like where one of the terminals (T2) is located in near-optimal or optimal conditions (e.g. near to the base station (101), having favorable propagation conditions, having line-of-sight to the base station (101), and/or the like as T1 above). The other terminal (T2') of the two advanced terminals is located in near-worst case, worst case, or less favorable conditions (e.g. relatively far away from the base station (101), at the cell edge, in a fading dip, and/or the like as T1').

In prior art systems, the broadcast control channel (BCCH) and the broadcast traffic channel (BTCH) are designed to accommodate the worst case whereby more advanced terminals and/or terminals located in more optimal situations can not resume their 'sleep' state conserving power faster than the terminals under the worst case situations or having more limited capabilities.

According to the present invention, broadcast information e.g. for a BCCH and/or a BTCH is provided that enables more advanced terminals (like terminal T2 and T2') and/or terminals located in more optimal situations (like terminal T1 and T2) than the worst case to optimize their power consumption during standby (BCCH) or when listening to a broadcast traffic channel (BTCH).

This is achieved according to the present invention by sending the broadcast information in increments, i.e. incrementally, enabling the terminals capable of it (due to better capabilities like higher information rate, greater bandwidth, etc. and/or due to better location like near the base station, having favorable propagation conditions, having line-of-sight to the base station, etc.) to receive the broadcast information more quickly and resuming a 'sleep' state (unless they are required to act in an active way upon the received broadcast information) sooner. The first increment or increments will be sufficient for more capable terminals or more favorably placed terminals to decode the broadcast message. Additional increments sent at a later point in time (including information at a lower data rate or including channel coding information) will be required by the less capable or less favorably placed terminals. The terminals being more capable will not need the increment information.

This allows terminals like T1, T2, T2' to resume their power saving mode faster while support for worst or worse case terminals like T1' is maintained.

An aspect of the present invention is shown and explained in greater detail in connection with Figure 2. Embodiments and alternatives of this aspect are shown and explained in connection with Figures 3a - 3e, 4, 5 and 6a - 6d.

Figure 2 schematically illustrates the use of incremental broadcast information according to one embodiment of the present invention. Shown is broadcast information (200), e.g. in the form of a broadcast message, that is sent incrementally in a number of consecutive slots or symbols (201, ..., 204) at different points in time.

In the first slot or symbol (201), a high rate broadcast message is e.g. sent which contains all the information needed for a terminal that is close to the base station of the cell (e.g. T1 and T2 in Figure 1) and thereby can do without channel coding and/or for a terminal that supports higher modulation schemes (e.g. T2 and T2' in Figure 1) and thereby can receive more information during each slot or symbol.

Preferably, the first symbol or slot also contains part of the broadcast message required for the terminals (e.g. T1' and T2' in Figure 1) that need channel coding and/or cannot support the higher modulation schemes (e.g. T1 and T1' in Figure 1) so they can benefit some from the information sent in the first slot or symbol. In one embodiment, this information is located in the part that can be received by terminals only supporting lower modulation schemes.

For less favorable and/or simpler terminals (e.g. T1, T1' and/or T2' in Figure 1), incremental broadcast information (205) is present in the second slot or symbol (202) (and even in additional slots or symbols (203, ...) if necessary).

As an example, let a broadcast message consist of parts 'A', 'B', 'C' and 'D'. The broadcast message may e.g. be sent with 'A' in the first time slot or symbol, 'B' in the second, 'C' in the third and 'D' in the last. Further, according to this embodiment of the present invention, 'C' could be sent in the first time slot or symbol together with 'A' and 'D' could be sent in the second time slot or symbol together with 'B'. Only the advanced or favorably located terminals will be able to extract message parts 'C' and 'D' in the first and second time slots or symbols in addition to the conventional parts 'A' and 'B'. Conventional or worst case terminals will only be able to extract 'A' and 'B' from the first and second time slots or symbols. Various other orderings may be just as applicable, e.g. 'A', 'C', 'B', 'D' sent during the four time slots or symbols and 'B' and 'D' sent in the first two time slot or symbols, etc. As long as the ordering is consistent and well known for the terminals.

The incremental information can e.g. in Time Division Multiple Access (TDMA) systems be sent at other slots or symbols than the ordinary broadcast information, i.e. at a later time instance.

In this way, advanced terminals (e.g. capable of receiving information at a high information rate) and terminals under favorable propagation conditions, e.g. close to the base station only have to receive this first slot or symbol (201) before they can resume their 'sleep' state and being conserving power. This is done without having to wait for the less capable (e.g. due to placement and/or capabilities) terminals as would be the case if the sending of broadcast information was designed to accommodate the worst or worse case situation(s). The less capable terminals receive the needed broadcast information during later slots or symbols as incremental broadcast information.

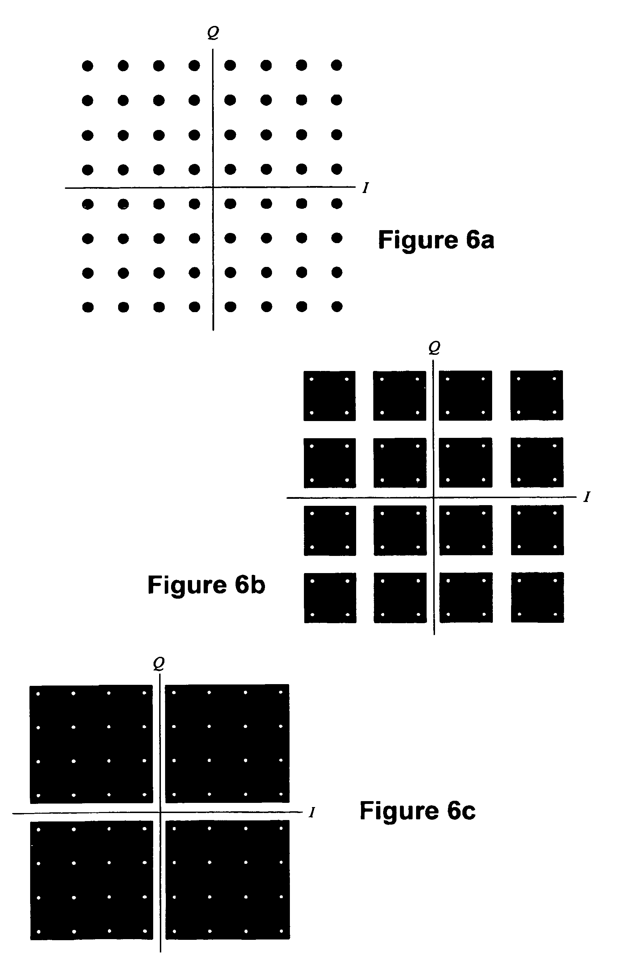

Please see Figures 3a - 3e and 6a - 6d and the related description for different embodiments of how to provide different information rates (high(er) and low(er)) to different terminals.

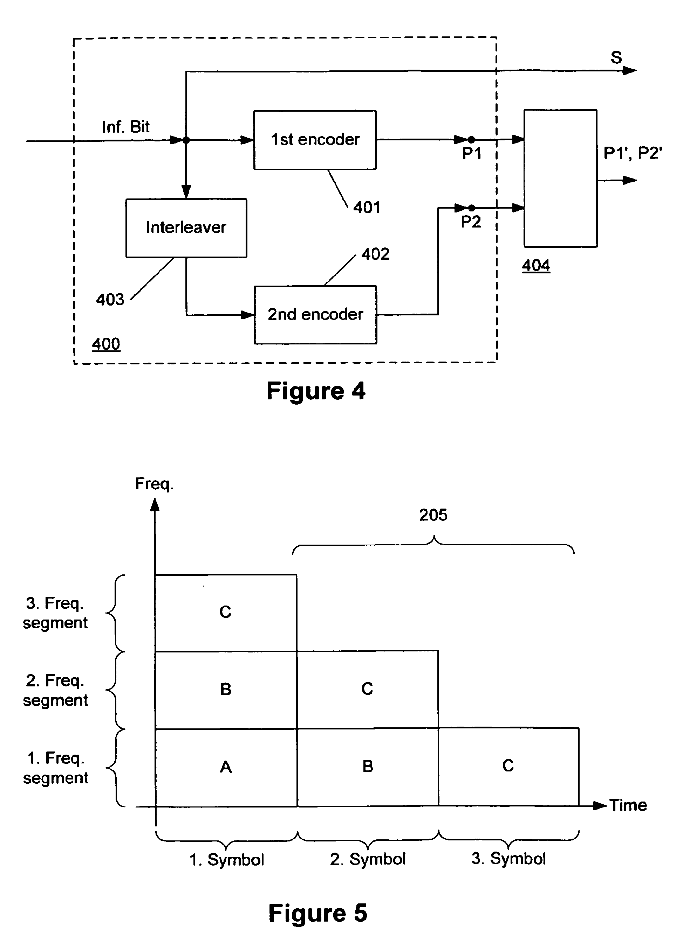

It is to be understood that more classes or groupings of terminals than two is just as possible. See e.g. the description in relation to Figure 5 for an example of 3 classes.

In certain systems, e.g. Orthogonal Frequency Division Multiplexing (OFDM) systems, bit streams are sent in parallel over a set of sub-carriers, each sub-carrier supporting a bit stream. The set of sub-carriers may for instance span a total bandwidth of 1.25 MHz. If each set, as an example, contain 100 sub-carriers and the operator has been allocated 5 MHz there is room for 4 complete sets or 400 sub-carriers. However, another operator that has been allocated 15 MHz has room for 12 sets or 1200 sub-carriers. Since, in this example, the set spans 1.25 MHz then the broadcast channel needs to be dimensioned for 1.25 MHz. However, with 5 MHz being available for the first operator it is according to the present invention possible to locate information only in the three additional sub-carrier sets (the second operator can locate information in 11 additional sub-carrier sets). Terminals that operate in the 1.25 MHz bandwidth (e.g. the low-cost and/or low-complexity terminals T1 and T1' in Figure 1) may require several OFDM symbols in order to receive the entire broadcast message. For the terminals operating in the 5 MHz bandwidth (e.g. the advanced terminals T2 and T2' in Figure 1), a single symbol (or at least fewer) may contain the entire broadcast message as it can accommodate four times as much information per symbol compared to when only the three additional sub-carriers are used.

As an example, a first part of the broadcast information is transmitted at a first frequency band (i.e. the first 100 sub-carriers in the example above), a second part of the broadcast information is transmitted at a second frequency band (i.e. the next 100 sub-carriers), and so on until all the broadcast information has been sent or all the available sets have been used. It has to be assured that the rest of information is sent to the terminals that only operate in the more limited frequency band at the next time instant(s). This is illustrated and explained in greater detail in connection with Figure 5.

In this way, terminals that have wideband capabilities will receive the broadcast information sooner and will therefore be able to enter their 'sleep' mode earlier thereby conserving additional power.

Figures 3a, 3b and 3c schematically illustrates different modulation schemes in order to provide different information rates to terminals within a cell.

According to this embodiment, a communications system supports different modulation schemes in order to provide different information rates to terminals within a cell.

As one example, a system is considered that uses QPSK (Quadrature Phase Shift Keying) modulation but where it is extended with a 16-QAM (Quadrature Amplitude Modulation) mode in order to double the data or information rate. In a conventional system, the broadcast control channels would all use QPSK, whereas only a dedicated (traffic) channel could apply 16-QAM.

According to an embodiment of the present invention, the broadcast channel is changed in such a way that it supports both QPSK transceivers (i.e. old or medium or low-tech terminals and/or terminals at the cell edge; e.g. T1, T1' and T2' in Figure 1) and 16-QAM transceivers (i.e. more advanced terminals capable of a high(er) bit or information rate and located nearer the base station; e.g. T2 in Figure 1). As an example, suppose that the broadcast information has a size of 8 bits. Since 2 bits pr. symbol can be sent in the QPSK then 4 symbols are needed for a QPSK terminal. However, since 4 bits pr. symbol can be sent in 16-QAM then only 2 symbols are needed for a 16-QAM terminal to receive the broadcast information. As mentioned, since the power consumption of a terminal is mainly determined by its up-time, the doubling of the date rate directly translates into a power consumption improvement by a factor of two. Only terminals that have both 16-QAM and a good location can benefit from the higher data rate. In this case, it is only T2 that can benefit. T1 may be close, but its receiver cannot handle the 16-QAM signal.

In this particular example, the 8-bit broadcast information is represented by bits b_0, b_1, ..., b_7. Bit b_0 is sent first. For a QPSK terminal it is required to map (b_0, b_1) to the first symbol, (b_2, b_3) to the second symbol, (b_4, b_5) to the third symbol and (b_6, b_7) to the fourth symbol as a QPSK terminal can only receive 2 bits pr. symbol. At the same time, for a 16-QAM terminal it is required to map (b_0, b_1, b 2, b_3) to the first symbol and (b_4, b_5, b_6, b_7,) to the second symbol as a 16-QAM terminal can receive 4 bits pr. symbol. Moreover, the first symbol for QPSK and the first symbol for 16-QAM must be one and the same symbol. Likewise, the second symbol for QPSK and the second symbol for 16-QAM must be one and the same symbol. This is achieved by using the constellation diagrams as shown in Figures 3a and 3b resulting in the ordering as shown in Figure 3c.

In Figure 3a the 16-QAM diagram is shown and in Figure 3b the corresponding QPSK diagram is shown. Please note that for QPSK, all points in the same quadrant map to the same 2-bit value (which is the b_A, b_B value of the 16-QAM constellation). For example '0001', '0011', '0000', and '0010' in Figure 3a all map or merge to the single point '0000' in Figure 3b. This can also be referred to as clustering, grouping or merging the four points of Figure 3a to the single point of Figure 3b. Also indicated schematically by the square hatched boxes in Figures 3a and 3b are the respective 'I' and 'Q' value intervals representing the different bit values. E.g. 'I' and 'Q' values in the intervals as given by hatched boxes (310) represents the value '0001'. The same 'I' and 'Q' values would according to the QPSK scheme give the value '00', as can be seen from Figure 3b. In this way, a 16-QAM capable terminal would receive '0001' by receiving 'I', 'Q' values (310) while a QPSK capable terminal would receive '0' for the same 'I', 'Q' values. The specific size of the intervals may vary according to the specific implementation.

Careful mapping of the information bits over the consecutive symbols is typically required. According to this embodiment, the first symbol shall contain b_0 and b_1 for both the QPSK terminal(s) and the 16-QAM terminal(s). The first symbol shall also contain b_2 and b_3 for the 16-QAM terminal(s). If the constellation points are represented by b_A, b_B, b_C, and b_D, then b_0 shall be mapped to b_A, while b_1 to b_B, b_2 to b_C, and finally b_3 to b_D. The second symbol shall contain b_4 and b_5 for both the QPSK terminal(s) and the 16-QAM terminal(s) and it shall also contain b_6 and b_7 for the 16-QAM terminal(s). b_4 shall be mapped to b_A, while b_5 to b_B, b_6 to b_C, and finally b_7 to b_D.

In this way, the 16-QAM terminal(s) can receive all 8 bits within two symbols only. The third symbol shall contain b_2 and b_3 for the QPSK terminal(s), while the fourth symbol shall contain b_6 and b_7 also for the QPSK terminal(s) being transmitted as incremental information (205). Please see Figure 3c for an overview of the above-mentioned ordering of the bits in the symbols for this particular example.

This mapping provides the correct bit order for the 16-QAM receiver, whereas the QPSK receiver has to do some bit reordering in order to get to the correct message. An alternative mapping could have the correct order for the QPSK receiver and a reordering requirement for the 16-QAM receiver. In such a mapping, (b_0, b_1), (b_2, b_3), (b 4, b_5), and (b_6, b_7) are mapped to (b_A , b_B) in the first, second, third and fourth symbols, respectively. In addition, (b_4, b_5) are mapped to (b_C, b_D) in the first symbol, and (b_6, b_7) are mapped to (b_C, b_D) in the second symbol.

The extra bits for the QPSK terminal(s) may be sent as incremental broadcast information incremented in time.

As an example, let b_0 = 1, b_1 = 0, b_2 = 1, and b_3 = 0 then the first symbol should be the constellation point '1010' in Figure 3a. This point would be interpreted as '1010' in a 16-QAM terminal while being interpreted as '10' in a QPSK terminal.

Preferably, for the third and fourth symbol, only the constellation points '0011', '1011', '1111', and '0111' shall be used by the transmitter as there is no information left for the 16-QAM terminal(s), whereas these constellation points have the best distance properties.

Although broadcast information having a size of 8 bits and the modulation schemes 16-QAM and QPSK are used, other embodiments are equally applicable. In this embodiment, the two modulation schemes 16-QAM and QPSK were used (as an example) where the QPSK symbols can be derived from the 16-QAM constellation by merging or mapping a cluster of four 16-QAM symbols to a single QPSK symbol. In an alternative embodiment, a 64-QAM scheme can be used (in addition to or instead of 16-QAM and/or QPSK) as explained in connection with Figures 6a - 6d.

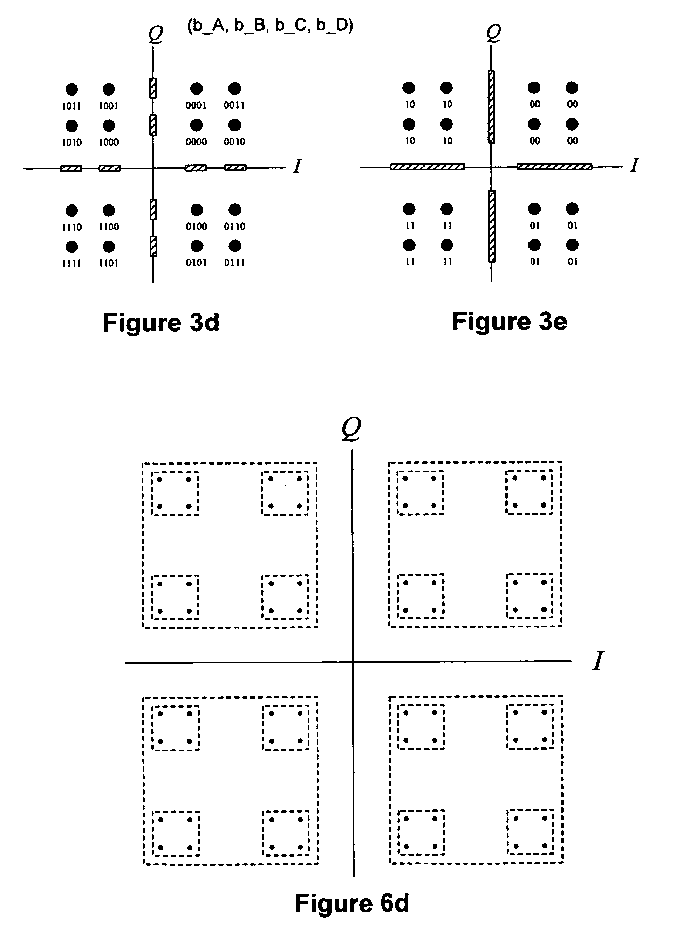

In the embodiment explained in connection with Figures 3a and 3b the constellation points are equidistant as traditionally is done. This is not as error robust when 16-QAM and QPSK symbols are carried simultaneously as it otherwise could be. See Figures 3d, 3e and 6d and related description for an alternative improved embodiment.

Figures 3d and 3e schematically illustrate an alternative embodiment of the one primarily described in connection with Figures 3a - 3c. As explained, the constellation points are equidistant in the embodiment explained in connection with Figures 3a and 3b. This is not as error robust when 16-QAM and QPSK symbols are carried simultaneously as it otherwise could be. For example in the upper right quadrant; for QPSK, the 16-QAM symbols '0000', '0001', '0010', and '0011' all signify the same QPSK symbol, namely '00. However, when the 16-QAM symbol '0000' is selected to convey the QPSK symbol '00' then '0000' is closer to its neighbors representing other QPSK symbols (and thus more vulnerable for errors) than if '0011' was selected.

According to an alternative embodiment and as illustrated in Figure 3d and 3e, the clusters (a cluster being a group of symbols in one scheme representing the same symbol in the other scheme) are spaced further apart thereby improving the error rate for the QPSK even more than already achieved due to the merging or mapping symbols into clusters. In this way, if '0000' is selected to convey the QPSK symbol '00' (in this particular mapping) the distance to its neighbors representing other QPSK symbols has been increased increasing the robustness further. Generally, points that have the biggest mutual spacing should be selected.

Figure 4 schematically illustrates an encoder according to one embodiment, of the present invention. Shown, as an example, is a 1/3-rate turbo encoder (400) like one used in UMTS. The encoder produces a systematic code. A systematic code is a code in which the information bits to be sent and the parity bits are clearly distinguishable.

For every information bit (Inf. Bit) that the encoder (400) receives it produces three coded bits (S, P1, P2) where the first bit S is identical to the received information bit (Inf. Bit) and P1 and P2 are parity bits. For example, an 8-bit broadcast message would be coded as a 24-bit word. The encoder (400) comprises a first encoder (401) receiving the information bits (Inf. Bit), and a second encoder (402) receiving the information bits that have been reordered by an interleaver (403). The reordering by interleaver (403) is part of the standard encoding scheme and plays a part in giving a boost of the Turbo code as generally known in the art. The first encoder (401) produces a first parity bit P1 and the second encoder (402) produces a second parity bit P2 for each information bit (Inf. Bit). Such encoders are also well known in the art.

According to an embodiment of the present invention, instead of sending the bits as they come out of the encoder, where one information bit, one parity bit P1 and one parity bit P2 would be sent before the next information bit is sent, all the information bits S are sent first followed by the parity bits P1 and P2. This enables terminals with good Signal to Noise Ration (SNR) (e.g. the terminals T1 and T2 in Figure 1) to only receive the systematic bits S in order to retrieve the broadcast information after which they can then go into their 'sleep' state. Less favorable terminals (e.g. T1' and T2' in Figure 1) may have to receive the parity bits P1 and/or P2 that arrive later in order to correct bit error(s). Not all parity bits need to be received. Parity bits that are not received can be considered as so-called punctured bits whereby they are treated in the same way as if the transmitter had not sent them.

In a preferred embodiment, the ordering of the set of parity bits P1 and the ordering of the set of parity bits P2 are randomized by a randomizer, (additional) interleaver, or the like (404) (performing pseudo-random permutation). As a result, the positions of the punctured bits are randomized, which makes the decoding process more robust.

In another embodiment, the encoder (400) receives and stores an information bit (Inf. Bit) and its associated parity bits (P1, P2) at each time instance e.g. by an accumulator or the like (not shown). After a number of bits have been stored (e.g. 100 bits) in the encoder (400) then the additional interleaver (404) generates a bit-stream of first the 100 information bits (Inf. Bit) and then 100 P1-bits followed by 100 P2-bits. After these bits have been sent, further bits are collected and the procedure repeats. In this way, favorable terminals just have to listen to the first 100 bits while non-favorable terminals have to listen to at least a part of the parity bits.

The present invention is equally applicable to a conventional encoder with systematic coding, i.e. without the additional interleaver (404). For these, virtual puncturing can also be assumed for the parity bits (P1, P2) that are not received.

In this way, terminals with good SNR are allowed to receive only the minimum amount of information before they can return to their 'sleep' state since they do not need any or some of the parity bits (P1 and P2) due to a proper placement and simple re-arrangement of the channel coding bits, i.e. all S's before P1 s and P2s.

The embodiment of Figure 4 can also be combined with that of Figure 3c. Bit pairs (b_2,b_3) and (b_6,b_7) can represent parity bits for the FEC coding. Advanced receivers can extract the parity bits from the first and second symbols, whereas conventional receivers will extract these bits from the third and fourth symbols.

Figure 5 schematically illustrates broadcast message segments distributed in time and frequency according to another embodiment of the present invention. As explained, certain terminals, e.g. in an OFDM system, may benefit from the broadcast information being sent at various frequencies at the same time instance (even though not all terminals may be capable of this).

As an example, consider a system with a carrier spacing of 12.5 kHz and a minimum use of 100 sub-carriers where the system can be extended with additional blocks or sets of 100 sub-carriers. In such a system the minimum bandwidth will be 1.25 MHz (100 times 12.5 kHz) and the system will be able to support bandwidths of 1.25 MHz, 2.5 MHz, 3.75 MHz, etc. due to the extension of additional sets of sub-carriers. Some operators may only use 2.5 MHz of their spectrum while other operators may use up to 15 MHz. Further, low-cost and/or low-complexity terminals (e.g. T1 and T1' in Figure 1) may support only 200 sub-carriers while more advanced terminals (e.g. T2 and T2' in Figure 1) may use 1200 sub-carriers.

Suppose, as an example, that one symbol (or slot) of information with 100 sub-carriers can contain a third of the broadcast information. For a system with 1.25 MHz bandwidth then three consecutive symbols are required to receive the entire broadcast information. However, a 2.5 MHz wide system with 200 sub-carriers per symbol will only require two symbols. Finally, a system with a bandwidth equal to or larger than 300 sub-carriers will only need a single symbol.

According to the present invention, the broadcast information is split up into, as an example, three parts A, B and C and part A is sent in the first set of 100 sub-carriers, i.e. in the first frequency segment, in the first symbol, part B is sent in second set of 100 sub-carriers, i.e. in the second frequency segment, in the first symbol, and part C is sent in the third set of 100 sub-carriers, i.e. in the third frequency segment in the first symbol. Further, part B is sent (again) in the first set of 100 sub-carriers, i.e. in the first frequency segment, in the second symbol and part C is sent (again) in the second set of 100 sub-carriers, i.e. in the second frequency segment, in the second symbol. Finally, part C is sent (once again) in the first set of 100 sub-carriers, i.e. in the first frequency segment, in the first symbol.

In this way, wider band terminals (like T2 and T2' in Figure 1) will need to listen for a shorter time window in order receive the entire broadcast information and can go into 'sleep' mode sooner thereby conserving power.

Figures 6a, 6b and 6c illustrate an alternative embodiment than the one primarily described in connection with Figures 3a - 3c. In this embodiment, , a 64-QAM scheme is used (in addition to or instead of 16-QAM and/or QPSK) where merging, grouping or mapping clusters of four 64-QAM symbols (see Figure 6a for all the 64-QAM symbols) into a cluster will give a 16-QAM scheme (see Figure 6b) and where merging, grouping or mapping clusters of four 16-QAM symbols will give a QPSK scheme (being the same as sixteen 64-QAM symbols being mapped to a QPSK symbol) (see Figure 6c). Embodiments may support two or more of 64-QAM, 16-QAM, QPSK and other schemes, i.e. certain terminals being supported by a base station could receive information according to the 64-QAM scheme, where other terminals could receive information according to the 16-QAM scheme and where yet other terminals could only receive information to the QPSK scheme. In this way, even though a same 'Q' 'I' pair is sent and received by all these types of different terminals they will obtain a different amount of information according to their scheme. The same principles may be applied to even more complex constellation diagrams like 128-QAM, 256-QAM, etc. In general, a first and at least a second modulation scheme may be supported, where the first modulation scheme comprises N constellation points and said second modulation scheme comprises M constellation points, where N and M are integers and M<N and where said M constellation points are a sub-constellation of the N constellation points.

Figure 6d summarizes the various groupings or clusters of the different schemes. The broken boxes surrounding the constellation points indicate the 'Q'-'I' intervals for each bit value corresponding to the hatched boxes in Figures 3a - 3e. In Figure 6d, it is also shown that the constellation points in the original 64-QAM scheme do not show a constant inter-spacing distance. Usage of the constellation for less dense modulation scheme will then have less impact on the robustness of the less dense modulation scheme, as also explained in connection with Figures 3d and 3e.

In the claims, any reference signs placed between parentheses shall not be constructed as limiting the claim. The word "comprising" does not exclude the presence of elements or steps other than those listed in a claim. The word "a" or "an" preceding an element does not exclude the presence of a plurality of such elements.

## Claims

1. A method of communicating broadcast information, the method comprising:
- transmitting broadcast information (200) comprising a first and a second part to at least one communications terminal (T1, T2, T1', T2'),
**characterized in that**
- the transmission comprises transmitting the broadcast information (200) during at least a first time instance and transmitting incremental broadcast information (205) by re-transmitting at least a part of said second part during a time instance being different from the first time instance.

2. A method according to claim 1, wherein the incremental broadcast information (205) comprises one or more selected from the group of:
- broadcast information (200) that has been transmitted at said first time instance,
- channel coding information,
- one or more parity bits (P1, P2), and
- one or more bits of information of an error correction scheme.

3. A method according to claim 1, wherein the broadcast information (200) comprises a number of parts (1. Freq. segment, 2. Freq. segment, 3. Freq. segment) wherein one part (1. Freq. segment, 2. Freq. segment; 3. Freq. segment) is transmitted at a first frequency range at said first time instance and wherein at least one of the other parts (1. Freq. segment, 2. Freq. segment, 3. Freq. segment) is transmitted at another frequency range at said first time instance and where the at least one of the other parts is retransmitted as incremental information (205) at said time instance being different from the first time instance.

4. A method according to claim 1, wherein said time instance being different from the first time instance is a time instance that is later in time than said first time instance.

5. A method according to claim 1, wherein a systematic encoder (400) outputs information bits (Inf. Bit, S) as said broadcast information (200) and a number of parity bits (P1, P2) as said incremental broadcast information (205) where the information bits (Inf. Bit, S) are transmitted first followed by one or more of the parity bits (P1, P2).

6. A method according to claim 5, wherein the parity bits (P1, P2) are randomly re-ordered by an interleaver (404) before being transmitted.

7. A method according to claim 1, wherein a first (16-QAM, 64-QAM) and at least a second (QPSK, 16-QAM) modulation scheme are supported during transmission and where the method comprises transmitting the broadcast information (200) according to the first modulation scheme (16-QAM; 64-QAM) and transmitting the incremental broadcast information (205) according to the second modulation scheme (QPSK, 16-QAM) where the first modulation scheme has a higher information rate than the second modulation scheme and where information transmitted in the second modulation scheme is transmitted as a part of the information in the first modulation scheme in at least one time instance.

8. A method according to claim 7, wherein the first modulation scheme ins16-QAM, the second modulation scheme is QPSK and the broadcast information (200) has a size of 8 bits, where the broadcast information (200) is arranged in a first block (b_0, b_1), a second block (b_2, b_3), a third block (b_4, b_5) and a fourth block (b_6, b_7), each of 2 bits, where
- the first and second blocks (b_0, b_1, b_2, b_3) are transmitted as the first symbol so that the first block (b_0, b_1) can be received according to both QPSK and to 16-QAM and so that the second block (b_2, b_3) can be received according to 16-QAM,
- the third and fourth blocks (b_4, b_5, b_6, b_7) are transmitted as the second symbol so that the third block (b_4, b_5) can be received according to both QPSK and to 16-QAM and so that the fourth block (b_6, b_7) can be received according to 16-QAM,
- the second block (b_2, b_3) is transmitted as the third symbol and is transmitted as incremental broadcast information (205) so that it can be received according to QPSK, and
- the fourth block (b_6, b_7) is transmitted as the fourth symbol and is transmitted as incremental broadcast information (205) so that it can be received according to QPSK.

9. A method according to claim 1, wherein a first and at least a second modulation scheme are supported during transmission and where the method comprises transmitting the broadcast information (200) according to the first modulation scheme and transmitting the incremental broadcast information (205) according to the second modulation scheme, where said first modulation scheme comprises N constellation points and said second modulation scheme comprises M constellation points, where N and M are integers and M<N and where said M constellation points are a sub-constellation of the N constellation points and where information sent in the second modulation scheme is sent as a part of the information in the first modulation scheme in at least one time instance.

10. A method according to claim 7 or 9, where constellation points of the first modulation scheme (16-QAM, 64-QAM) that is used for constellation points of the second modulation scheme (QPSK, 16-QAM) are selected to be points that have the biggest mutual spacing.

11. A method according to claim 1, wherein a first and at least a second modulation scheme are supported during transmission and where the method comprises transmitting the broadcast information (200) according to the first modulation scheme and transmitting the incremental broadcast information (205) according to the at least second modulation scheme, where the first modulation scheme is selected from the group of: 16-QAM and 64-QAM and where the at least second modulation scheme is one or more selected from the group of QPSK and 16-QAM.

12. A method according to claim 7, wherein constellation points in a Q-I space are non-equidistant, where constellation points within a given cluster are substantially equidistant and where clusters of constellation points are placed further apart compared to a placement of clusters of constellation points, where all the constellation points are equidistant.

13. A method according to any one of claims 1 - 12, wherein said method further comprises receiving, by a terminal (T1, T2, T1', T2') comprising a communications receiver, said first and said second part at a given time instance or receiving said first part at said given time instance and said second part at a time instance being different from said given time instance.

14. A system for communicating broadcast information, the system comprising:
- a transmitter adapted to transmit broadcast information (200) comprising a first and a second part to at least one communications terminal (T1, T2, T1', T2'),
**characterized in that** the transmitter is further adapted to
- transmit the broadcast information (200) during at least a first time instance and to transmit incremental broadcast information (205) by re-transmitting at least a part of said second part during a time instance being different from the first time instance.

15. A system according to claim 14, wherein the incremental broadcast information (205) comprises one or more selected from the group of:
- broadcast information (200) that has been transmitted at said first time instance,
- channel coding information,
- one or more parity bits (P1, P2), and
- one or more bits of information of an error correction scheme.

16. A system according to claim 14, wherein the broadcast information (200) comprises a number of parts (1. Freq. segment, 2. Freq. segment, 3. Freq. segment) and wherein the transmitter is adapted to transmit one part (1. Freq. segment, 2. Freq. segment, 3. Freq. segment) at a first frequency range at said first time instance and to transmit at least one of the other parts (1. Freq. segment, 2. Freq. segment, 3. Freq. segment) at another frequency range at said first time instance and to re-transmit the at least one of the other parts as incremental information (205) at said time instance being different from the first time instance.

17. A system according to claim 14, wherein said time instance being different from the first time instance is a time instance that is later in time than said first time instance.

18. A system according to claim 14, wherein the system comprises a systematic encoder (400) adapted to output information bits (Inf, Bit, S) as said broadcast information (200) and a number of parity bits (P1, P2) as said incremental broadcast information (205) where the transmitter is adapted to transmit information bits (Inf. Bit, S) first followed by one or more of the parity bits (P1, P2).

19. A system according to claim 18, wherein system further comprises an interleaver (404) for randomly re-ordering the parity bits (P1, P2) before they are transmitted.

20. A system according to claim 14, wherein a first (16-QAM, 64-QAM) and at least a second (QPSK, 16-QAM) modulation scheme are supported during transmission and where the system is adapted to transmit the broadcast information (200) according to the first modulation scheme (16-QAM, 64-QAM) and transmit the incremental broadcast information (205) according to the second modulation scheme (QPSK, 16-QAM), where the first modulation scheme has a higher information rate than the second modulation scheme and where the system is further adapted to transmit information transmitted in the second modulation scheme as a part of the information in the first modulation scheme in at least one time instance.

21. A system according to claim 20, wherein the first modulation scheme is 16-QAM, the second modulation scheme is QPSK and the broadcast information (200) has a size of 8 bits, where the broadcast information (200) is arranged in a first block (by_0, b_1), a second block (b_2, b_3), a third block (b_4, b_5) and a fourth block (b_6, b_7), each of 2 bits, where the transmitter is adapted to transmit
- the first and second blocks (b_0, b_1, b_2, b_3) as the first symbol so that the first block (b_0, b_1) can be received according to both QPSK and to 16-QAM and the second block (b_2, b_3) as incremental broadcast information (205) so that the second block (b_2, b_3) can be received according to 16-QAM,
- the third and fourth blocks (b_4, b_5, b_6, b_7) as the second symbol so that the third block (b_4, b_5) can be received according to both QPSK and to 16-QAM and so that the fourth block (b_6, b_7) can be received according to 16-QAM,
- the second block (b_2, b_3) as the third symbol as incremental information (205) so that it can be received according to QPSK, and
- the fourth block (b_6, b_7) as the fourth symbol as incremental information (205) so that it can be received according to QPSK.

22. A system according to claim 14, wherein the system is adapted to support a first and at least a second modulation scheme during transmission and where the system is adapted to transmit the broadcast information (200) according to the first modulation scheme and transmit the incremental broadcast information (205) according to the second modulation scheme, where said first modulation scheme comprises N constellation points and said second modulation scheme comprises M constellation points, where N and M are integers and M<N and where said M constellation points are a sub-constellation of the N constellation points and where the system is further adapted to transmit information transmitted in the second modulation scheme as a part of the information in the first modulation scheme in at least one time instance.

23. A system according to claim 20 or 22, where constellation points of the first modulation scheme (16-QAM, 64-QAM) that is used for constellation points of the second modulation scheme (QPSK, 16-QAM) are selected to be points that have the biggest mutual spacing.

24. A system according to claim 14, wherein the system is adapted to support a first and at least a second modulation scheme during transmission and where the system is adapted to transmit the broadcast information (200) according to the first modulation scheme and transmit the incremental broadcast information (205) according to the at least second modulation scheme, where the first modulation scheme is selected from the group of: 16-QAM and 64-QAM and where the at least second modulation scheme is one or more selected from the group of QPSK and 16-QAM.

25. A system according to claim 21, wherein constellation points in a Q-I space are non-equidistant, where constellation points within a given cluster are substantially equidistant and where clusters of constellation points are placed further apart compared to a placement of clusters of constellation points, where all the constellation points are equidistant.

26. A system according to any one of claims 14 - 25, wherein said system further comprises a terminal (T1, T2, T1', T2') comprising a communications receiver adapted to receive said first and said second part at a given time instance or to receive said first part at said given time instance and said second part at a time instance being different from said given time instance.

27. A transmitter unit comprising a communications transmitter adapted to transmit broadcast information (200) comprising a first and a second part to at least one communications terminal (T1, T2, T1', T2'), **characterized in that** the transmitter unit is further adapted to transmit the broadcast information (200) during at least a first time instance and to transmit incremental broadcast information (205) by re-transmitting at least a part of said second part during a time instance being later than the first time instance.

28. A computer readable medium having stored thereon instructions for causing one or more processing units to execute the method according to any one of claims 1 - 13.

## Patentansprüche

1. Verfahren zum Kommunizieren von Broadcast-Informationen, wobei das Verfahren umfasst:
- Senden von Broadcast-Informationen (200), die einen ersten und einen zweiten Teil umfassen, an mindestens ein Kommunikationsendgerät (T1, T2, T1', T2'),
**dadurch gekennzeichnet, dass**
- die Übertragung ein Senden der Broadcast-Informationen (200) während mindestens eines ersten Zeitpunkts und Senden von Broadcast-Einzelinformationen (205) durch erneutes Senden mindestens eines Teils des zweiten Teils während eines vom ersten Zeitpunkt verschiedenen Zeitpunkts umfasst.

2. Verfahren nach Anspruch 1, wobei die Broadcast-Einzelinformationen (205) eine oder mehrere aus der folgenden Gruppe ausgewählte umfassen:
- Broadcast-Informationen (200), die zum ersten Zeitpunkt gesendet wurden,
- Kanalcodierungsinformationen,
- ein oder mehr Paritätsbits (P1, P2) und
- ein oder mehr Bits von Informationen eines Fehlerkorrekturschemas.

3. Verfahren nach Anspruch 1, wobei die Broadcast-Informationen eine Anzahl von Teilen (1. Freq. segment, 2. Freq. segment, 3. Freq. segment) umfassen, wobei ein Teil (1. Freq. segment, 2. Freq. segment, 3. Freq. segment) in einem ersten Frequenzbereich zum ersten Zeitpunkt gesendet wird, und wobei mindestens einer der anderen Teile (1. Freq. segment, 2. Freq. segment, 3. Freq. segment) in einem anderen Frequenzbereich zum ersten Zeitpunkt gesendet wird, und wobei mindestens einer der anderen Teile als Einzelinformation (205) zu dem vom ersten Zeitpunkt verschiedenen Zeitpunkt erneut gesendet wird.

4. Verfahren nach Anspruch 1, wobei der vom ersten Zeitpunkt verschiedene Zeitpunkt ein Zeitpunkt ist, der zeitlich später als der erste Zeitpunkt ist.

5. Verfahren nach Anspruch 1, wobei ein systematischer Codierer (400) Informationsbits (Inf. Bit, S) als die Broadcast-Informationen (200) und eine Anzahl von Paritätsbits (P1, P2) als die Broadcast-Einzelinformationen (205) ausgibt, wobei die Informationsbits (Inf. Bit, S) zuerst gesendet werden, gefolgt von einem oder mehreren der Paritätsbits (P1, P2).

6. Verfahren nach Anspruch 5, wobei die Paritätsbits (P1, P2) durch einen Verschachteler (404) vor ihrer Übertragung zufallsmäßig neu geordnet werden.

7. Verfahren nach Anspruch 1, wobei ein erstes (16-QAM, 64-QAM) und mindestens ein zweites (QPSK, 16-QAM) Modulationsschema während der Übertragung unterstützt werden, und wobei das Verfahren ein Senden der Broadcast-Informationen (200) gemäß dem ersten Modulationsschema (16-QAM; 64-QAM) und Senden der Broadcast-Einzelinformationen (205) gemäß dem zweiten Modulationsschema (QPSK, 16-QAM) umfasst, wobei das erste Modulationsschema eine höhere Informationsrate als das zweite Modulationsschema aufweist, und wobei Informationen, die im zweiten Modulationsschema gesendet werden, als ein Teil der Informationen im ersten Modulationsschema zu mindestens einem Zeitpunkt gesendet werden.

8. Verfahren nach Anspruch 7, wobei das erste Modulationsschema 16-QAM ist, das zweite Modulationsschema QPSK ist und die Broadcast-Informationen (200) eine Größe von 8 Bit aufweisen, wobei die Broadcast-Informationen (200) in einem ersten Block (b_0, b_1), einem zweiten Block (b_2, b_3), einem dritten Block (b_4, b_5) und einem vierten Block (b_6, b_7) von je 2 Bit angeordnet sind, wobei:
- die ersten und zweiten Blöcke (b_0, b_1 b_2, b_3) als das erste Symbol gesendet werden, so dass der erste Block (b_0, b_1) sowohl gemäß QPSK als auch gemäß 16-QAM empfangen werden kann und so dass der zweite Block (b_2, b_3) gemäß 16-QAM empfangen werden kann,
- die dritten und vierten Blöcke (b_4, b_5, b_6, b_7) als das zweite Symbol gesendet werden, so dass der dritte Block (b_4, b_5) sowohl gemäß QPSK als auch gemäß 16-QAM empfangen werden kann und so dass der vierte Block (b_6, b_7) gemäß 16-QAM empfangen werden kann,
- der zweite Block (b_2, b_3) als das dritte Symbol gesendet wird und als Broadcast-Einzelinformation (205) gesendet wird, so dass er gemäß QPSK empfangen werden kann, und
- der vierte Block (b_6, b_7) als das vierte Symbol gesendet wird und als Broadcast-Einzelinformation (205) gesendet wird, so dass er gemäß QPSK empfangen werden kann.

9. Verfahren nach Anspruch 1, wobei ein erstes und mindestens ein zweites Modulationsschema während der Übertragung unterstützt werden, und wobei das Verfahren ein Senden der Broadcast-Informationen (200) gemäß dem ersten Modulationsschema und Senden der Broadcast-Einzelinformationen (205) gemäß dem zweiten Modulationsschema umfasst, wobei das erste Modulationsschema N Konstellationspunkte umfasst und das zweite Modulationsschema M Konstellationspunkte umfasst, wobei N und M ganze Zahlen sind und M < N, und wobei die M Konstellationspunkte eine Subkonstellation der N Konstellationspunkte sind, und wobei Informationen, die im zweiten Modulationsschema gesendet werden, als ein Teil der Informationen im ersten Modulationsschema zu mindestens einem Zeitpunkt gesendet werden.

10. Verfahren nach Anspruch 7 oder 8, wobei Konstellationspunkte des ersten Modulationsschemas (16-QAM, 64-QAM), das für Konstellationspunkte des zweiten Modulationsschemas (QPSK, 16-QAM) verwendet wird, so ausgewählt werden, dass sie Punkte sind, die den größten gegenseitigen Abstand aufweisen.

11. Verfahren nach Anspruch 1, wobei ein erstes und mindestens ein zweites Modulationsschema während der Übertragung unterstützt werden, und wobei das Verfahren ein Senden der Broadcast-Informationen (200) gemäß dem ersten Modulationsschema und Senden der Broadcast-Einzelinformationen (205) gemäß dem zweiten Modulationsschema umfasst, wobei das erste Modulationsschema aus der Gruppe von 16-QAM und 64-QAM ausgewählt ist, und wobei das mindestens zweite Modulationsschema eines oder mehr ist, das/die aus der Gruppe von QPSK und 16-QAM ausgewählt ist/sind.

12. Verfahren nach Anspruch 7, wobei Konstellationspunkte im Q-I-Raum nicht äquidistant sind, wobei Konstellationspunkte innerhalb eines bestimmten Clusters im Wesentlichen äquidistant sind, und wobei Cluster von Konstellationspunkten gegenüber einer Anordnung von Clustern von Konstellationspunkten, bei welchen alle Konstellationspunkte äquidistant sind, weiter auseinander angeordnet sind.

13. Verfahren nach einem der Ansprüche 1 bis 12, wobei das Verfahren ferner ein Empfangen durch das Endgerät (T1, T2, T1', T2'), das einen Kommunikationsempfänger umfasst, des ersten und des zweiten Teils zu einem bestimmten Zeitpunkt oder Empfangen des ersten Teils zum bestimmten Zeitpunkt und des zweiten Teils zu einem vom bestimmten Zeitpunkt verschiedenen Zeitpunkt umfasst.

14. System zum Kommunizieren von Broadcast-Informationen, wobei das System umfasst:
- einen Sender, der so ausgelegt ist, dass er Broadcast-Informationen (200), die einen ersten und einen zweiten Teil umfassen, an mindestens ein Kommunikationsendgerät (T1, T2, T1', T2') sendet,
**dadurch gekennzeichnet, dass** der Sender ferner ausgelegt ist zum:
- Senden der Broadcast-Informationen (200) während mindestens eines ersten Zeitpunkts und zum Senden von Broadcast-Einzelinformationen (205) durch erneutes Senden mindestens eines Teils des zweiten Teils während eines vom ersten Zeitpunkt verschiedenen Zeitpunkts.

15. System nach Anspruch 14, wobei die Broadcast-Einzelinformationen (205) eine oder mehrere aus der folgenden Gruppe ausgewählte umfassen:
- Broadcast-Informationen (200), die zum ersten Zeitpunkt gesendet wurden,
- Kanalcodierungsinformationen,
- ein oder mehr Paritätsbits (P1, P2) und
- ein oder mehr Bits von Informationen eines Fehlerkorrekturschemas.

16. System nach Anspruch 14, wobei die Broadcast-Informationen eine Anzahl von Teilen (1. Freq. segment, 2. Freq. segment, 3. Freq. segment) umfassen, und wobei der Sender so ausgelegt ist, dass er einen Teil (1. Freq. segment, 2. Freq. segment, 3. Freq. segment) in einem ersten Frequenzbereich zum ersten Zeitpunkt sendet und mindestens einen der anderen Teile (1. Freq. segment, 2. Freq. segment, 3. Freq. segment) in einem anderen Frequenzbereich zum ersten Zeitpunkt sendet, und den mindestens einen der anderen Teile als Einzelinformation (205) zu dem vom ersten Zeitpunkt verschiedenen Zeitpunkt erneut sendet.

17. System nach Anspruch 14, wobei der vom ersten Zeitpunkt verschiedene Zeitpunkt ein Zeitpunkt ist, der zeitlich später als der erste Zeitpunkt ist.

18. System nach Anspruch 14, wobei das System einen systematischen Codierer (400) umfasst, der so ausgelegt ist, dass er Informationsbits (Inf. Bit, S) als die Broadcast-Informationen (200) und eine Anzahl von Paritätsbits (P1, P2) als die Broadcast-Einzelinformationen (205) ausgibt, wobei der Sender so ausgelegt ist, dass er Informationsbits (Inf. Bit, S) zuerst sendet, gefolgt von einem oder mehreren der Paritätsbits (P1, P2).

19. System nach Anspruch 18, wobei das System ferner einen Verschachteler (404) zum zufallsmäßigen Neuordnen der Paritätsbits (P1, P2) vor ihrer Übertragung umfasst.

20. System nach Anspruch 14, wobei ein erstes (16-QAM, 64-QAM) und mindestens ein zweites (QPSK, 16-QAM) Modulationsschema während der Übertragung unterstützt werden, und wobei das System so ausgelegt ist, dass es die Broadcast-Informationen (200) gemäß dem ersten Modulationsschema (16-QAM; 64-QAM) sendet und die Broadcast-Einzelinformationen (205) gemäß dem zweiten Modulationsschema (QPSK, 16-QAM) sendet, wobei das erste Modulationsschema eine höhere Informationsrate als das zweite Modulationsschema aufweist, und wobei das System ferner so ausgelegt ist, dass es Informationen, die im zweiten Modulationsschema gesendet werden, als einen Teil der Informationen im ersten Modulationsschema zu mindestens einem Zeitpunkt sendet.

21. System nach Anspruch 20, wobei das erste Modulationsschema 16-QAM ist, das zweite Modulationsschema QPSK ist und die Broadcast-Informationen (200) eine Größe von 8 Bit aufweisen, wobei die Broadcast-Informationen (200) in einem ersten Block (b_0, b_1), einem zweiten Block (b_2, b_3), einem dritten Block (b_4, b_5) und einem vierten Block (b_6, b_7) von je 2 Bit angeordnet sind, wobei der Sender ausgelegt ist zum Senden:
- der ersten und zweiten Blöcke (b_0, b_1, b_2, b_3) als das erste Symbol, so dass der erste Block (b_0, b_1) sowohl gemäß QPSK als auch gemäß 16-QAM empfangen werden kann, und des zweiten Blocks (b_2, b_3) als Broadcast-Einzelinformation (205), so dass der zweite Block (b_2, b_3) gemäß 16-QAM empfangen werden kann,
- der dritten und vierten Blöcke (b_4, b_5, b_6, b_7) als das zweite Symbol, so dass der dritte Block (b_4, b_5) sowohl gemäß QPSK als auch gemäß 16-QAM empfangen werden kann und so dass der vierte Block (b_6, b_7) gemäß 16-QAM empfangen werden kann,
- des zweiten Blocks (b_2, b_3) als das dritte Symbol als Broadcast-Einzelinformation (205), so dass er gemäß QPSK empfangen werden kann, und
- des vierten Blocks (b_6, b_7) als das vierte Symbol als Broadcast-Einzelinformation (205), so dass er gemäß QPSK empfangen werden kann.

22. System nach Anspruch 14, wobei das System so ausgelegt ist, dass es ein erstes und mindestens ein zweites Modulationsschema während der Übertragung unterstützt, und wobei das System so ausgelegt ist, dass es die Broadcast-Informationen (200) gemäß dem ersten Modulationsschema sendet und die Broadcast-Einzelinformationen (205) gemäß dem zweiten Modulationsschema sendet, wobei das erste Modulationsschema N Konstellationspunkte umfasst und das zweite Modulationsschema M Konstellationspunkte umfasst, wobei N und M ganze Zahlen sind und M < N, und wobei die M Konstellationspunkte eine Subkonstellation der N Konstellationspunkte sind, und wobei das System ferner so ausgelegt ist, dass es Informationen, die im zweiten Modulationsschema gesendet werden, als einen Teil der Informationen im ersten Modulationsschema zu mindestens einem Zeitpunkt sendet.

23. System nach Anspruch 20 oder 22, wobei Konstellationspunkte des ersten Modulationsschemas (16-QAM, 64-QAM), das für Konstellationspunkte des zweiten Modulationsschemas (QPSK, 16-QAM) verwendet wird, so ausgewählt werden, dass sie Punkte sind, die den größten gegenseitigen Abstand aufweisen.

24. System nach Anspruch 14, wobei das System so ausgelegt ist, dass es ein erstes und mindestens ein zweites Modulationsschema während der Übertragung unterstützt, und wobei das System so ausgelegt ist, dass es die Broadcast-Informationen (200) gemäß dem ersten Modulationsschema sendet und die Broadcast-Einzelinformationen (205) gemäß dem zweiten Modulationsschema sendet, wobei das erste Modulationsschema aus der Gruppe von 16-QAM und 64-QAM ausgewählt ist, und wobei das mindestens zweite Modulationsschema eines oder mehr ist, das/die aus der Gruppe von QPSK und 16-QAM ausgewählt ist/sind.

25. System nach Anspruch 21, wobei Konstellationspunkte im Q-I-Raum nicht äquidistant sind, wobei Konstellationspunkte innerhalb eines bestimmten Clusters im Wesentlichen äquidistant sind, und wobei Cluster von Konstellationspunkten gegenüber einer Anordnung von Clustern von Konstellationspunkten, bei welchen alle Konstellationspunkte äquidistant sind, weiter auseinander angeordnet sind.

26. System nach einem der Ansprüche 14 bis 25, wobei das System ferner ein Endgerät (T1, T2, T1', T2') umfasst, das einen Kommunikationsempfänger umfasst, der so ausgelegt ist, dass er den ersten und den zweiten Teil zu einem bestimmten Zeitpunkt empfängt oder den ersten Teil zum bestimmten Zeitpunkt und den zweiten Teil zu einem vom bestimmten Zeitpunkt verschiedenen Zeitpunkt empfängt.

27. Sendereinheit, umfassend einen Kommunikationssender, der so ausgelegt ist, dass er Broadcast-Informationen (200), die einen ersten und einen zweiten Teil umfassen, an mindestens ein Kommunikationsendgerät (T1, T2, TI', T2') sendet, **dadurch gekennzeichnet, dass** die Sendereinheit ferner so ausgelegt ist, dass sie die Broadcast-Informationen (200) während mindestens eines ersten Zeitpunkts sendet und Broadcast-Einzelinformationen (205) durch erneutes Senden mindestens eines Teils des zweiten Teils während eines Zeitpunkts sendet, der später als der erste Zeitpunkt ist.

28. Computerlesbares Medium, das Befehle darauf gespeichert aufweist, um eine oder mehr Verarbeitungseinheiten zu veranlassen, das Verfahren nach einem der Ansprüche 1 bis 13 auszuführen.

## Revendications

1. Procédé de communication d'information de diffusion, le procédé comprenant de :
- transmettre une information de diffusion (200) comprenant une première et une seconde partie à au moins un terminal de communication (T1,T2,T1',T2'), **caractérisé en ce que**
- la transmission comprend de transmettre l'information de diffusion (200) pendant au moins une première instance temporelle et transmettre une information de diffusion incrémentielle (205) en retransmettant au moins une partie de ladite seconde partie pendant une instance temporelle étant différente de la première instance temporelle.

2. Procédé selon la revendication 1, dans lequel l'information de diffusion incrémentielle (205) comprend un ou plusieurs sélectionnés parmi le groupe de :
- une information de diffusion (200) qui a été transmise au niveau de ladite première instance temporelle,
- une information de codage de canal,
- un ou plusieurs bits de parité (P1,P2), et
- un ou plusieurs bits d'information d'un système de correction d'erreur.

3. Procédé selon la revendication 1, dans lequel l'information de diffusion (200) comprend une pluralité de parties (1 Freq.segment, 2.Freq.segment, 3 Freq.segment) dans lequel une partie 1 Freq.segment, 2.Freq.segment, 3 Freq.segment)est transmise à une première plage de fréquence à ladite première instance temporelle et dans lequel au moins une des autres parties 1 Freq.segment, 2.Freq.segment, 3 Freq.segment) est transmise à une autre plage de fréquence à ladite première instance temporelle et dans lequel au moins une des autres parties est retransmise comme information incrémentielle (205) à ladite instance temporelle étant différente de la première instance temporelle.

4. Procédé selon la revendication 1, dans lequel ladite instance temporelle étant différente de la première instance temporelle est une instance temporelle qui est plus tardive dans le temps que ladite première instance temporelle.

5. Procédé selon la revendication 1, dans lequel un codeur systématique (400) délivre des bits d'information (Inf.Bit, S) en tant que ladite information de diffusion (200) et une pluralité de bits de parité (P1,P2)en tant que ladite information de diffusion incrémentielle (205) dans lequel les bits d'information (Inf.Bit, S)sont transmis en premier suivi par un ou plusieurs des bits de parité (P1,P2).

6. Procédé selon la revendication 5, dans lequel les bits de parité (P1,P2) sont réordonnés aléatoirement par un dispositif d'entrelacement (404) avant d'être transmis.

7. Procédé selon la revendication 1, dans lequel un premier (16-QAM, 64-QAM) et au moins un second (QPSK, 16-QAM) système de modulation sont pris en charge pendant la transmission et le procédé comprend de transmettre l'information de diffusion (200) selon le premier système de modulation (16-QAM, 64-QAM) et transmettre l'information de diffusion incrémentielle (205) selon le second système de modulation (QPSK, 16-QAM) dans lequel le premier système de modulation a un plus grand taux d'information que le second système de modulation et dans lequel l'information transmise dans le second système de modulation est transmise en tant que partie de l'information dans le premier système de modulation dans au moins une instance temporelle.

8. Procédé selon la revendication 7, dans lequel le premier système de modulation est 16-QAM, le second système de modulation est QPSK et l'information de diffusion (200) a une taille de 8 bits, dans lequel l'information de diffusion (200) est agencée en un premier bloc (b_o,b_1), un second bloc (b_2,b_3), un troisième bloc (b_4,b_5) et un quatrième bloc (b_6,b_7), de 2 bits chacun, dans lequel
- le premier et le second bloc (b_0,b_1,b_2,b_3) sont transmis comme le premier symbole de sorte que le premier bloc (b_0,b_1) puisse être reçu selon à la fois QPSK et 16-QAM et de sorte que le second bloc (b_2,b_3) puisse être reçu selon 16-QAM,
- le troisième et le quatrième bloc (b_4,b_5,b_6,b_7) sont transmis comme le second symbole de sorte que le troisième bloc (b_4,b_5) puisse être reçu selon à la fois QPSK et 16-QAM et de sorte que le quatrième bloc (b_6,b_7) puisse être reçu selon 16-QAM,
- le second bloc (b_2,b_3) est transmise comme le troisième symbole et est transmis en tant qu'information de diffusion incrémentielle (20) de sorte qu'il puisse être reçu selon QPSK, et
- le quatrième bloc (b_6,b_7) est transmis comme le quatrième symbole et est transmis comme une information de diffusion incrémentielle (205) de sorte qu'il puisse être reçu selon QPSK.

9. Procédé selon la revendication 1, dans lequel un premier et au moins un second système de modulation sont pris en charge pendant la transmission et le procédé comprend de transmettre l'information de diffusion (200) selon le premier système de modulation et transmettre l'information de diffusion incrémentielle (205) selon le second système de modulation, dans lequel ledit premier système de modulation comprend N points de constellation et ledit second système de modulation comprend M points de constellation, dans lequel N et M sont des entiers et M<N et dans lequel lesdits M points de constellation sont une sous-constellation des N points de constellation et l'information envoyée dans le second système de modulation est envoyée en tant qu'une partie de l'information dans le premier système de modulation dans au moins une instance temporelle.

10. Procédé selon les revendications 7 ou 9, dans lequel les points de constellation du premier système de modulation (16-QAM, 64-QAM) qui est utilisé pour les points de constellation du second système de modulation (QPSK, 16-QAM) sont sélectionnés afin d'être des points qui ont le plus grand espacement mutuel.

11. Procédé selon la revendication 1, dans lequel un premier et au moins un second système de modulation sont pris en charge pendant la transmission et le procédé comprend de transmettre l'information de diffusion (200) selon le premier système de modulation et transmettre l'information de diffusion incrémentielle (205) selon au moins le second système de modulation, dans lequel le premier système de modulation est sélectionné parmi le groupe de : 16-QAM et 64-QAM et au moins le second système de modulation est un ou plusieurs sélectionné parmi le groupe de QPSK et 16-QAM.

12. Procédé selon la revendication 7, dans lequel les points de constellation dans un espace Q-I sont non équidistants, dans lequel les points de constellation à l'intérieur d'une grappe donnée sont substantiellement équidistants et les grappes de points de constellation sont placés avec un plus grand espacement comparé à un placement de grappes de points de constellation où tous les points de constellation sont équidistants.

13. Procédé selon une quelconque des revendications 1 à 12, dans lequel ledit procédé comprend en outre de recevoir, par un terminal (T1,T2,T1',T2') comprenant un récepteur de communications, ladite première et ladite seconde partie à une instance temporelle donnée ou recevoir ladite première partie à ladite instance temporelle donnée et ladite seconde partie à une instance temporelle étant différente de ladite instance temporelle donnée.

14. Système de communication d'information de diffusion, le système comprenant :
- un émetteur adapté pour émettre une information de diffusion (200) comprenant une première et une seconde partie vers au moins un terminal de communication (T1,T2,T1',T2'), **caractérisé en ce que** l'émetteur est en outre adapté pour :
- émettre l'information de diffusion (200) pendant au moins une première instance temporelle et émettre l'information de diffusion incrémentielle (205) en retransmettant au moins une partie de ladite seconde partie pendant une instance temporelle étant différente de la première instance temporelle.

15. Système selon la revendication 14, dans lequel l'information de diffusion incrémentielle (205) comprend un ou plusieurs sélectionnés parmi le groupe de :
- une information de diffusion (200) qui a été transmise au niveau de ladite première instance temporelle,
- une information de codage de canal,
- un ou plusieurs bits de parité (P1,P2), et
- un ou plusieurs bits d'information d'un système de correction d'erreur.

16. Système selon la revendication 14, dans lequel l'information de diffusion (200) comprend une pluralité de parties (1 Freq.segment, 2.Freq.segment, 3 Freq.segment) dans lequel une partie 1 Freq.segment, 2.Freq.segment, 3 Freq.segment)est transmise à une première plage de fréquence à ladite première instance temporelle et dans lequel au moins une des autres parties 1 Freq.segment, 2.Freq.segment, 3 Freq.segment) est transmise à une autre plage de fréquence à ladite première instance temporelle et dans lequel au moins une des autres parties est retransmise comme information incrémentielle (205) à ladite instance temporelle étant différente de la première instance temporelle.

17. Système selon la revendication 14, dans lequel ladite instance temporelle étant différente de la première instance temporelle est une instance temporelle qui est plus tardive dans le temps que ladite première instance temporelle.

18. Système selon la revendication 14, dans lequel le système comprend un codeur systématique (400) adapté pour délivrer des bits d'information (Inf.Bit, S) en tant que ladite information de diffusion (200) et une plurlaité de bits de parité (P1,P2)en tant que ladite information de diffusion incrémentielle (205) dans lequel les bits d'information (Inf.Bit, S)sont transmis en premier suivi par un ou plusieurs des bits de parité (P1,P2).

19. Système selon la revendication 18, dans lequel le système comprend en outre un dispositif d'entrelacement (404) pour réordonner aléatoirement les bits de parité (P1,P2) avant qu'ils soient transmis.

20. Système selon la revendication 14, dans lequel un premier (16-QAM, 64-QAM) et au moins un second (QPSK, 16-QAM) système de modulation sont pris en charge pendant la transmission et le procédé comprend de transmettre l'information de diffusion (200) selon le premier système de modulation (16-QAM, 64-QAM) et transmettre l'information de diffusion incrémentielle (205) selon le second système de modulation (QPSK, 16-QAM) dans lequel le premier système de modulation a un plus grand taux d'information que le second système de modulation et dans lequel l'information transmise dans le second système de modulation est transmise en tant que partie de l'information dans le premier système de modulation dans au moins une instance temporelle.

21. Système selon la revendication 20, dans lequelle premier système de modulation est 16-QAM, le second système de modulation est QPSK et l'information de diffusion (200) a une taille de 8 bits, dans lequel l'information de diffusion (200) est agencée en un premier bloc (b_o,b_1), un second bloc (b_2,b_3), un troisième bloc (b_4,b_5) et un quatrième bloc (b_6,b_7), de 2 bits chacun, dans lequel l'émetteur est adapté afin d'émettre
- le premier et le second bloc (b_0,b_1,b_2,b_3) sont transmise comme le premier symbole de sorte que le premier bloc (b_0,b_1) puisse être reçu selon à la fois QPSK et 16-QAM et de sorte que le second bloc (b_2,b_3) puisse être reçu selon 16-QAM,
- le troisième et le quatrième bloc (b_4,b_5,b_6,b_7) sont transmis comme le second symbole de sorte que le troisième bloc (b_4,b_5) puisse être reçu selon à la fois QPSK et 16-QAM et de sorte que le quatrième bloc (b_6,b_7) puisse être reçu selon 16-QAM,
- le second bloc (b_2,b_3) est transmise comme le troisième symbole et est transmis en tant qu'information de diffusion incrémentielle (20) de sorte qu'il puisse être reçu selon QPSK, et
- le quatrième bloc (b_6,b_7) est transmis comme le quatrième symbole et est transmis comme une information de diffusion incrémentielle (205) de sorte qu'il puisse être reçu selon QPSK.

22. Système selon la revendication 14, dans lequel le système est adapté afin de prendre en charge un premier et au moins un second système de modulation pendant la transmission et dans lequel le système est adapté afin de transmettre l'information de diffusion (200) selon le premier système de modulation et transmettre l'information de diffusion incrémentielle (205) selon le second système de modulation, dans lequel ledit premier système de modulation comprend N points de constellation et ledit second système de modulation comprend M points de constellation, dans lequel N et M sont des entiers et M<N et dans lequel lesdits M points de constellation sont une sous-constellation des N points de constellation et l'information envoyée dans le second système de modulation est envoyée en tant qu'une partie de l'information dans le premier système de modulation dans au moins une instance temporelle.

23. Système selon les revendications 20 ou 22, dans lequel les points de constellation du premier système de modulation (16-QAM, 64-QAM) qui est utilisépour les points de constellation du second système de modulation (QPSK, 16-QAM) sont sélectionnés afin d'être des points qui ont le plus grand espacement mutuel.

24. Système selon la revendication 14, dans lequel le système est adapté afin de prendre en charge un premier et au moins un second système de modulation pendant la transmission et le système est adapté afin de transmettre l'information de diffusion (200) selon le premier système de modulation et transmettre l'information de diffusion incrémentielle (205) selon au moins le second système de modulation, dans lequel le premier système de modulation est sélectionné parmi le groupe de : 16-QAM et 64-QAM et au moins le second système de modulation est un ou plusieurs sélectionné parmi 1 groupe de QPSK et 16-QAM.

25. Système selon la revendication 21, dans lequel les points de constellation dans un espace Q-I sont non équidistants, dans lequel les points de constellation à l'intérieur d'une grappe donnée sont substantiellement équidistants et les grappes de points de constellation sont placés avec un plus grand espacement comparé à un placement de grappes de points de constellation où tous les points de constellation sont équidistants.

26. Système selon une quelconque des revendications 14 à 25, dans lequel ledit système comprend en outre un terminal (T1,T2,T1',T2') comprenant un récepteur de communication adapté afin de recevoir ladite première et ladite seconde partie à une instance temporelle donnée ou recevoir ladite première partie à ladite instance temporelle donnée et ladite seconde partie à une instance temporelle étant différente de ladite instance temporelle donnée.

27. Unité d'émetteur comprenant un émetteur de communications adapté afin d'émettre une information de diffusion (200) comprenant une première et une seconde partie vers au moins un terminal de communications (T1,T2,T1',T2'), **caractérisé en ce que** l'unité d'émetteur est en outre adaptée afin d'émettre l'information de diffusion (200) pendant au moins une première instance temporelle et émettre une information de diffusion incrémentielle (205) en retransmettant au moins une partie de ladite seconde partie pendant une instance temporelle étant plus tardive que la première instance temporelle.

28. Support lisible par ordinateur sur lequel sont mémorisées des instructions pour amener une ou plusieurs unités de traitement à exécuter le procédé selon une quelconque des revendications 1 à 13.
